# EUROPEAN PATENT SPECIFICATION

(11) **EP 1 785 765 B1**
(45) Date of publication and mention of the grant of the patent: **13.01.2010**
(21) Application number: 06023388.9
(22) Date of filing: 10.11.2006
(51) Int. Cl.: G02F 1/13357, H01L 27/32, H01L 51/50, H04M 1/02

(54) **Display device emitting light from both sides**
Von beiden Seiten Licht emittierende Anzeigevorrichtung
Dispositif d'affichage émettant de la lumière de deux côtés

(30) Priority: 15.11.2005 KR 20050109141
(43) Date of publication of application: 16.05.2007
(73) Proprietor: Samsung Electronics Co., Ltd., Yeongtong-gu Suwon-city, Gyeonggi-do 442-742 (KR)
(72) Inventor: Jung, Jae-hoon, Seongnam-si Gyeonggi-do (KR); Kim, Nam-deog, Yongin-si Gyeonggi-do (KR)
(74) Representative: Dr. Weitzel & Partner

(56) References cited:
- EP-A- 1 496 496
- EP-A1- 1 496 497
- EP-A2- 1 319 972
- WO-A-2005/010595
- JP-A- 59 037 530
- JP-A- 2002 072 207

## Description

### BACKGROUND OF THE INVENTION

### Field of the Invention

The present invention relates to a display device and a manufacturing method thereof, and more particularly, to a display device which displays an image on both sides of a display region using an organic light emitting diode ("OLED") and a liquid crystal display ("LCD").

### Description of the Related Art

Recently, flat panel displays such as a liquid crystal displays ("LCDs") or organic light emitting diode ("OLED") displays have become widely used in the replacement of cathode ray tubes ("CRTs").

The LCD comprises a liquid crystal display panel having a liquid crystal layer. As the liquid crystal display panel does not emit light by itself, a backlight unit is disposed on a rear part of a thin film transistor to emit light to the display.

The organic light emitting diode ("OLED") display has recently become popular because it is driven with a low voltage; is thin and light; has a wide view angle; has a relatively short response time; and several other advantageous features. OLED displays are classified into passive matrix type and active matrix type according to their driving methods. The active matrix type is capable of realizing a wide screen and high resolution while the manufacturing process thereof may be complicated.

Meanwhile, a display device which displays images on both sides of a display region, like internal/external display windows of a folder type cell phone, has drawn attention. In the conventional display device displaying an image on both sides, a backlight unit is disposed between a pair of liquid crystal display panels as described in EP 1 319 972 A2. The display device described in EP 1 319 972 A2 includes the features of the preamble of appended claim 1.

With such a configuration, the conventional display device requires a single backlight unit to be disposed between the two liquid crystal display panels. However, the backlight unit may increase the thickness of the conventional display apparatus.

### BRIEF SUMMARY OF THE INVENTION

Accordingly, it is an aspect of the present invention to provide a display device which is thin in thickness and displays an image on both sides.

The foregoing and/or other aspects of the present invention can be achieved by providing a display device as defined in the appended independent claim 1. Further aspects of the present invention are defined in the appended dependent claims.

### BRIEF DESCRIPTION OF THE DRAWINGS

The above and/or other aspects, features and advantages of the present invention will become apparent and more readily appreciated from the following description of exemplary embodiments, taken in conjunction with the accompany drawings of which:
FIG. 1 is a cross-sectional view of a first exemplary embodiment of a display device according to the present invention;
FIG. 2 is an enlarged cross-sectional view of the first exemplary embodiment of a display device according to the present invention;
FIGS. 3-5 are cross-sectional views of second through fourth exemplary embodiments of a display device according to the present invention;
FIG. 6A is a front perspective view of an exemplary embodiment of an electronic device utilizing the exemplary embodiment of a display device according to the present invention; and
FIG. 6B is a front perspective view of an alternative configuration of an exemplary embodiment of an electronic device utilizing the exemplary embodiment of a display device according to the present invention.

### DETAILED DESCRIPTION OF THE INVENTION

The invention now will be described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another elements as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

Hereinafter, the present invention will be described in detail with reference to the accompanying drawings.

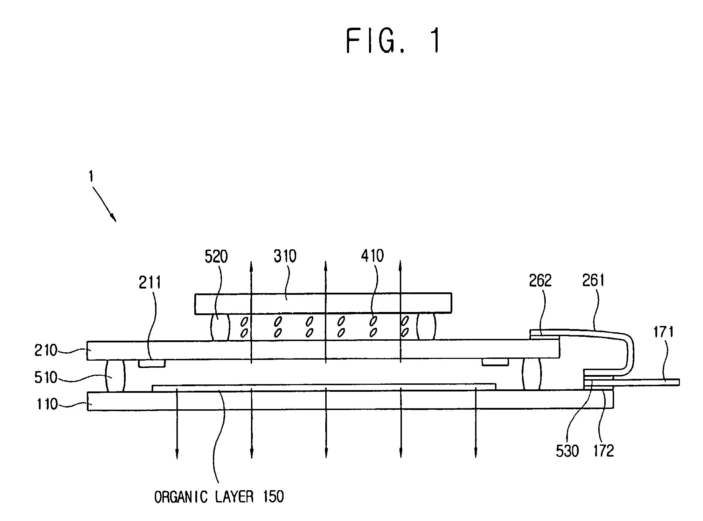

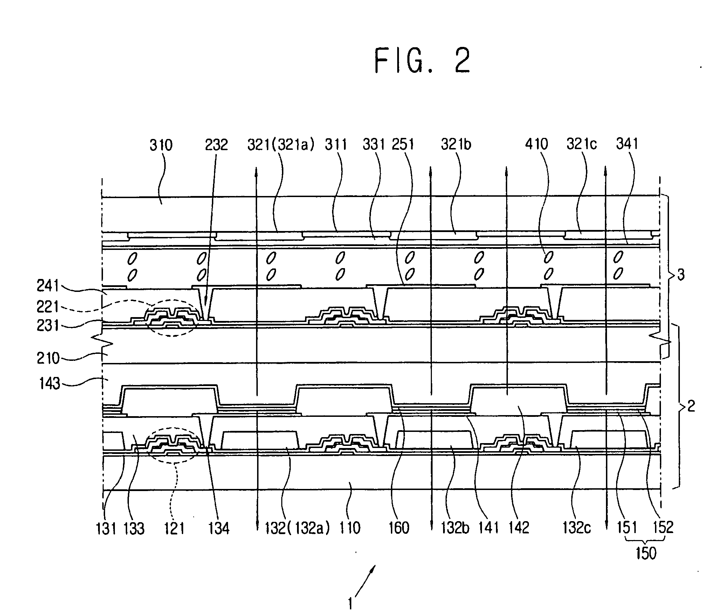

Hereinafter, a display device according to a first exemplary embodiment of the present invention will be described in detail with reference to FIGS. 1 and 2. An exemplary embodiment of a display device 1 according to the present invention comprises an organic light emitting diode ("OLED") display 2 and a liquid crystal display ("LCD") 3. The OLED display 2 and the LCD 3 share a second insulating substrate 210. The LCD 3 receives light from the OLED display 2.

The OLED display 2 comprises a first insulating substrate 110 and the second insulating substrate 210 which are in contact with each other through a first sealant 510; a first thin film transistor 121; and an organic layer 150 which are formed on the first insulating substrate 110.

Hereinafter, the OLED display 2 will be described in detail.

The first thin film transistor 121 is formed on the first insulating substrate 110, exemplary embodiments of which comprise an insulating material such as glass, quartz, ceramic or various plastics. Exemplary embodiments of the first TFT 121 of the OLED display 2 according to the present invention may be made of amorphous silicon as a semiconductor layer. Alternative exemplary embodiments include configurations wherein the first TFT 121 of the OLED display 2 according to the present invention may be made of a thin film transistor which employs poly-silicon or an organic semiconductor. In the exemplary embodiment of an OLED display 2, a single pixel comprises two or more thin film transistors including a switching thin film transistor and a driving thin film transistor. The first thin film transistor 121 shown in FIG. 2 comprises a driving thin film transistor.

A first passivation layer 131 is formed on the first thin film transistor 121. Exemplary embodiments of the first passivation layer 131 may be made of silicon nitride ("SiNx").

A first color filter 132 is disposed on the first passivation layer 131. The first color filter 132 is disposed as an island between adjacent first thin film transistors 121. The first color filter 132 is disposed having a predetermined pattern, and comprises sub layers 132a, 132b and 132c which differ in color.

A first organic layer 133 is formed on the first passivation layer 131 and the first color filter 132. Exemplary embodiments of the first organic layer 133 may comprise one of benzocyclobutene, olefin, acrylic resin, polyimide and fluoropolymer. A part of the first passivation layer 131 and the first organic layer 133 are either not formed on the first thin film transistor 121, or are formed thereon but are subsequently removed therefrom, thereby forming a contact hole 134.

A first pixel electrode 141 is formed on the first organic layer 133. The first pixel electrode 141 may also be referred to as an anode and supplies a hole to an organic layer 150. Exemplary embodiments of the first pixel electrode 141 are made of a transparent conductive material such as indium tin oxide ("ITO") or indium zinc oxide ("IZO"). The first pixel electrode 141 is connected with the first thin film transistor 121 through the contact hole 134.

A partition wall 142 is formed on the first pixel electrode 141 and the first organic layer 134, surrounding the first pixel electrode 141. The partition wall 142 partitions the pixel electrode 141 and forms a pixel region. Exemplary embodiments of the partition wall 142 may be made of a photosensitive material having thermal resistance and solvent resistance such as acrylic resin or polyimide, or an inorganic material such as SiO2 or Ti02. Alternative exemplary embodiments include configurations wherein the partition wall 142 may comprise a double layer configuration including an organic layer and an inorganic layer.

The organic layer 150 is formed on region of the first pixel electrode 141 which is left uncovered by the partition wall 142. The organic layer 150 comprises a hole injecting layer 151 and an organic light emitting layer 152 which are made of a polymer.

Exemplary embodiments of the hole injecting layer 151 are made of a hole injecting material such as poly (3,4-ethylenedeoxythiophene) ("PEDOT") and polystyrene sulfonic acid ("PSS"). In one exemplary embodiment the hole injecting material is mixed with water and formed by an inkjet method in an aqua suspension state.

The organic light emitting layer 152 emits a white light and according to one exemplary embodiment of the present invention may be formed by the inkjet method. In one exemplary embodiment the organic light emitting layer 152 emits white light and is formed of the same material in every pixel. Alternative exemplary embodiments include configurations wherein the organic light emitting layer 152 emits light of various colors. In such an alternative exemplary embodiment the color filters 132a-132c may be excluded. In such an alternative exemplary embodiment the second color filters 321 to be described below may also be omitted.

The hole transmitted by the first pixel electrode 141 and an electron supplied by a first common electrode 160 are combined as an exciton in the organic light emitting layer 152, thereby generating light through the de-excitation of the exciton.

The first common electrode 160 is formed on the partition wall 142 and the organic light emitting layer 152. The first common electrode 160 is also referred to as a cathode and supplies an electron to the organic light emitting layer 152.

A transparent layer 143 is formed on top of the first common electrode 160 to allow for a uniform bonding surface to be applied to the second insulating substrate 210.

The exemplary embodiment of an OLED display 2 according to the present invention displays an image toward the first insulating substrate 110 and at the same time supplies light to the LCD 3. Accordingly, the light emitted from the organic light emitting layer 152 is supplied to both the first insulating substrate 110 and the second insulating substrate 210. In order to do so the first common electrode 160 is transparent.

Exemplary embodiments of the first common electrode 160 may be made of a mixture of magnesium and silver or of calcium and silver. Exemplary embodiments of the first common electrode 160 may be about 50 nm to about 200 nm in thickness. When the first common electrode 160 is less than about 50 nm in thickness, a resistance thereof may increase to the point that common voltage supply becomes inefficient. When the first common electrode 160 is about 200 nm or more in thickness, the first common electrode 160 may become opaque. In one exemplary embodiment light transmittivity of the first common electrode 160 is about 50% or more.

Exemplary embodiments of the second insulating substrate 210 connected with the first insulating substrate 110 through the first sealant 510 may comprise an insulating material such as glass, quartz, ceramic or plastic. The second insulating substrate 210 may be smaller than the first insulating substrate 110 to allow for the easy mounting of a driving circuit substrate 171 to an end part of the first insulating substrate 110.

Since the organic layer 150 is susceptible to moisture, exemplary embodiments of the first sealant 510 have a moisture transmittivity of about 60 g/m² day or less. Exemplary embodiments of the first sealant 510 may be made of UV curing resin. The first sealant 510 may comprise a spacer (not shown) to keep intervals between the first insulating substrate 110 and the second insulating substrate 210 uniform.

A moisture absorber 211 is provided on the second insulating substrate 210 in the space between the second insulating substrate 210 and the first insulating substrate 110. Exemplary embodiments of the moisture absorber 211 may employ Ca, CaO, Ba, BaO, Mg, MgO, AlO or other similar substances. Exemplary embodiments of the moisture absorber 211 may be formed by a sputtering method or by an electron beam deposition method. Alternative exemplary embodiments include configurations wherein the moisture absorber 211 may be formed on the first insulating substrate 110.

The driving circuit substrate 171 is attached to a first end of the first insulating substrate 110. The driving circuit substrate 171 receives a signal from the outside to control the first thin film transistor 121 and to display an image. In one exemplary embodiment the driving circuit substrate 171 is connected with the first insulating substrate 110 through an anisotropic conductive film 172.

The LCD 3 comprises the second insulating substrate 210 and a third insulating substrate 310 which are in contact with each other by a second sealant 520; a second thin film transistor 221 which is formed on the second insulating substrate 210; a second color filter 321 which is formed on the third insulating substrate 310; and a liquid crystal layer 410 which is disposed between the second and third insulating substrates 210 and 310. In one exemplary embodiment the size of the liquid crystal layer 410 is smaller than that of the organic layer 150. The liquid crystal layer 410 is provided to be overlapped by the organic layer 150 or the organic light emitting layer 152. That is, the liquid crystal layer 410 is made to have a display region which is smaller than the OLED display 2.

Hereinafter, the LCD 3 will be described in detail.

The second thin film transistor 221 is formed on the second insulating substrate 210. Exemplary embodiments of the second insulating substrate 210 may be made of an insulating material such as glass, quartz, ceramic or various plastics. Exemplary embodiments of the second thin film transistor 221 are made of amorphous silicon as a semiconductor layer, but the present invention is not limited thereto. Alternative exemplary embodiments of the second thin film transistor 221 may be made of poly-silicon or an organic semiconductor.

A second passivation layer 231 is formed on the second thin film transistor 221. Exemplary embodiments of the second passivation layer 231 may be made of silicon nitride ("SiNx").

A second organic layer 241 is formed on the second passivation layer 231. Exemplary embodiments of the second organic layer 241 may comprise one of BCB, olefin, acrylic resin, polyimide and fluoropolymer. A part of the second passivation layer 231 and the second organic layer 241 is either not laid down on or is subsequently removed from the second thin film transistor 221, thereby forming a contact hole 232.

A second pixel electrode 251 is formed on the second organic layer 241. Exemplary embodiments of the second pixel electrode 251 are made of a transparent conductive material such as indium tin oxide ("ITO") or indium zinc oxide ("IZO") The second pixel electrode 251 is connected with the second thin film transistor 221 through the contact hole 232.

The third insulating substrate 310 is connected with the second insulating substrate 210 through the second sealant 520. Exemplary embodiments of the third insulating substrate 310 comprise an insulating material such as glass, quartz, ceramic or various plastics. The third insulating substrate 310 is smaller in size than the second insulating substrate 210, allowing the easy mounting of a flexible printed circuit board ("FPCB") 261 to an end part of the second insulating substrate 210. Also, the third insulating substrate 310 needs not be larger than the liquid crystal layer 410.

A black matrix 311 is formed on the third insulating substrate 310. The black matrix 311 is formed in a matrix pattern and prevents external light from being supplied to a channel area of the second thin film transistor 221. Exemplary embodiments of the black matrix 311 may comprise chrome oxide or organic matter including a black pigment.

The second color filter 321 is formed in the openings of the black matrix 311. The second color filter 321 comprises three sub layers 321a, 321b and 321c which are different in color.

An overcoat layer 331 is formed on the second color filter 321. The overcoat layer 331 provides a flat surface on which a second common electrode 341 is disposed.

The second common electrode 341 is formed on the overcoat layer 331. Exemplary embodiments of the second common electrode 341 are made of a transparent conductive material such as indium tin oxide ("ITO") or indium zinc oxide ("IZO"). The second common electrode 341 supplies a voltage to the liquid crystal layer 410 together with the second pixel electrode 251, thereby adjusting an arrangement of the liquid crystal layer 410. The orientation of liquid crystal molecules in the liquid crystal layer 410 may be modified by an electric field to either transmit or block polarized light from passing therethrough. It is also possible for the liquid crystal molecule to allow a fraction of the light to pass through while blocking the rest depending on the voltage difference between the second common electrode 341 and the second pixel electrode; in this manner a gray scale may be established for each pixel.

The flexible printed circuit board 261 is attached to a first end of the second insulating substrate 210. In one exemplary embodiment the flexible printed circuit board 261 is bent and connected with the driving circuit substrate 171. Between the flexible printed circuit board 261 and the second insulating substrate 210 and between the flexible printed circuit board 261 and the driving circuit substrate 171 are provided anisotropic conductive films 262 and 530.

In the LCD 3, the second insulating substrate 210 and the third insulating substrate 310 may respectively comprise a polarization plate (not shown) which is formed on a surface of each substrate closest to the liquid crystal layer.

Hereinafter, a process of operating the first exemplary embodiment of a display device 1 according to the present invention will be described.

When the OLED display 2 operates, the driving circuit substrate 171 supplies a driving signal to the OLED display 2, but not to the LCD 3. The white light emitted by the organic light emitting layer 152 according to the driving signal passes through the first insulating substrate 110 and the first color filter 132, and in passing through the color filter is tinted a color to display an image. The white light is transmitted to the second insulating substrate 210, but the image is not displayed since the LCD 3 does not receive the driving signal. When the LCD 3 is in a black mode, e.g., when the liquid crystal molecules are arranged so as to block the passage of light, the white light is not emitted to the outside of the LCD 3.

When the LCD 3 operates, the driving circuit substrate 171 supplies the driving signal to the LCD 3 to display the image, and to the OLED display 2 so that the organic light emitting layer 152 emits light uniformly. The uniform light generated by the organic light emitting layer 152 is incident to the liquid crystal layer 410 through the first common electrode 160 and the second insulating substrate 210. The transmittivity of the light incident to the liquid crystal layer 410 is adjusted by the liquid crystal layer 410 as described above. Then, the light passes through the second color filter 321 and receives the colored light to display the image. The light emitted by the organic light emitting layer 152 and transmitted to the first insulating substrate 110 receives the color when passing through the first color filter 132. Here, the OLED display 2 does not display the image, and instead displays a white picture.

When the LCD 3 operates, the OLED display 2 may operate in other modes. For example, the OLED display 2 may supply the white light to a region of the display device 1 which overlaps the liquid crystal layer 410. Also, the organic light emitting layer 152 corresponding to a dark region of the image displayed by the LCD 3 may supply a light at a low brightness and the organic light emitting layer 152 corresponding to a bright region supplies a light at a high brightness.

The first exemplary embodiment of an OLED display 2 according to the present invention operates as a backlight of the LCD 3. Accordingly, an additional backlight unit is not required, thereby reducing the thickness of the display device 1. Particularly, the OLED display 2 and the LCD 3 share the second insulating substrate 210, thereby further reducing the thickness of the display device 1.

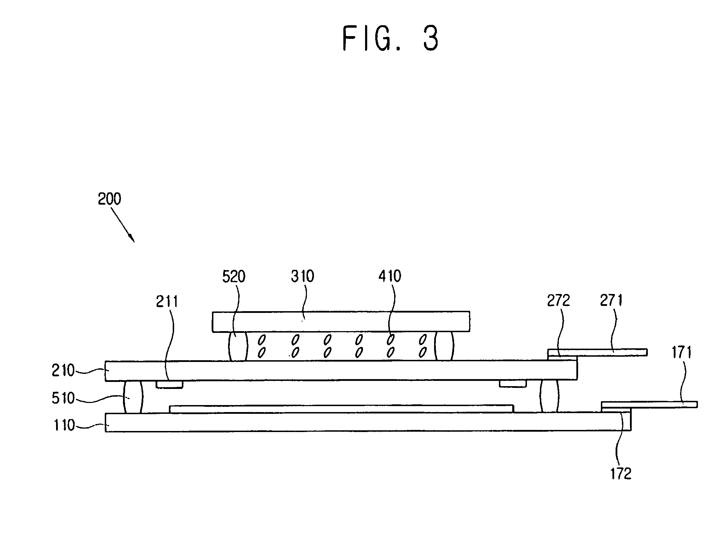

FIGS. 3-5 are cross-sectional views of second through fourth exemplary embodiments of a display device according to the present invention.

As shown in FIG. 3, in a second exemplary embodiment of a display device 200 according to the present invention, a first insulating substrate 110 and a second insulating substrate 210 are connected with driving circuit substrates 171 and 271, respectively. Anisotropic conductive films 172 and 272 are provided between the driving circuit substrate 171 and the first insulating substrate 110, and between the driving circuit substrate 271 and the second insulating substrate 210, respectively.

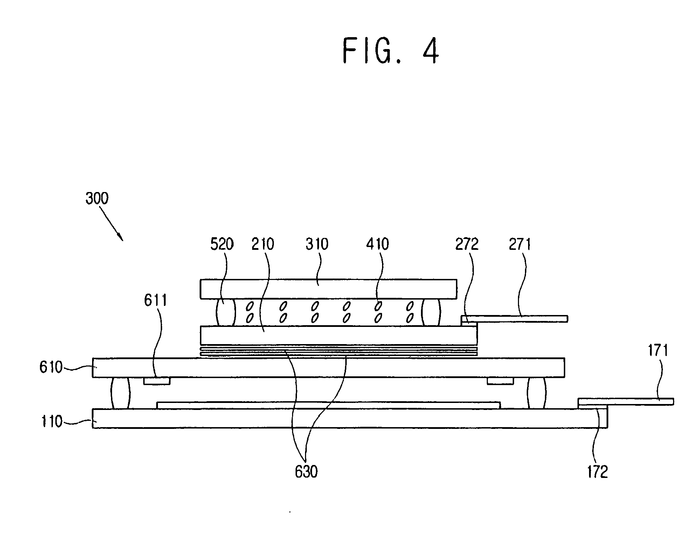

As shown in FIG. 4, an OLED display 2 and an LCD 3 of a third exemplary embodiment of a display device 300 according to the present invention do not share an insulating substrate. The OLED display 2 comprises a first insulating substrate 110 and a fourth insulating substrate 610. The LCD 3 comprises a second insulating substrate 210 and a third insulating substrate 310. A driving circuit substrate 271 and an anisotropic conductive film 272 are provided on an end part of the second insulating substrate 210. A moisture absorber 611 is provided on the fourth insulating substrate 610 on the surface nearest to the first insulating substrate 110.

An optical film 630 is disposed between the second insulating substrate 210 and the fourth insulating substrate 610. The optical film 630 may comprise one of a diffusion film, a prism film and a reflection polarization film. The optical film 630 improves uniformity and planarization of light emitted by the OLED display 2, thereby improving overall display picture quality of the LCD 3.

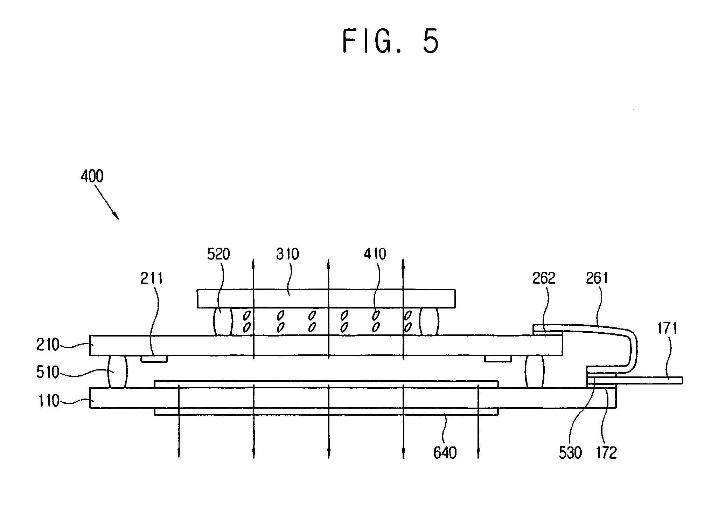

As shown in FIG. 5, in a fourth exemplary embodiment of a display device 400 according to the present invention, a color filter film 640 is attached to the outside of a first insulating substrate 110. The color filter film 640 may comprise a black matrix which is formed on a film in a matrix pattern, and plurality of sub layers which are formed in the holes of the black matrix and have differing colors. A manufacturing process of the OLED display 2 can thereby be simplified.

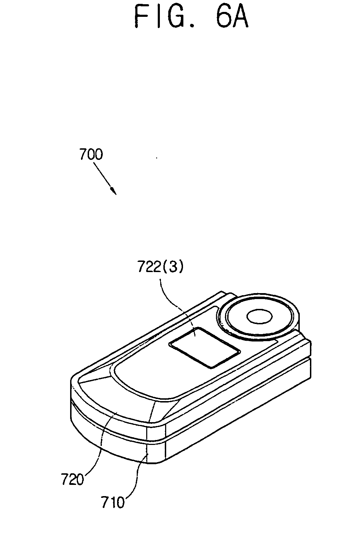

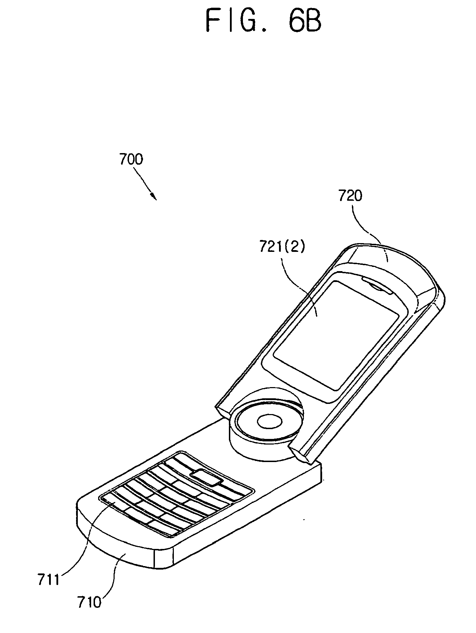

FIGS. 6A and 6B are front perspective views of an exemplary embodiment of an electronic device utilizing the exemplary embodiment of a display device according to the present invention. FIG. 6A shows the exemplary embodiment of a display device in a closed configuration and FIG. 6B shows the exemplary embodiment of a display device in an open configuration.

An electronic device 700 comprises a folding-type cell phone. The electronic device 700 comprises a main body 710 which has a key pad 711, as shown in FIG. 7B; and a display part 720 which is rotatably connected with the main body 710 and displays an image thereon.

The display part 720 comprises an internal display window 721 which is relatively large-sized and displays an image when the electronic device 700 is unfolded. The internal display window may be made of the OLED display 2. The display part 720 also comprises an external display window 722 which is relatively small-sized and displays an image when the electronic device 700 is folded. The external display window may be made of the LCD 3.

The display device 1 according to the present invention may be mounted to the display part 720. The internal display window 721 may employ the OLED display 2 and the external display window 722 may employ the LCD 3. The display device 1 according to the present invention is thin without an additional backlight unit, thereby reducing the thickness of the display part 720.

As described above, the present invention provides a display device which is thin in thickness and displays an image on both sides.

Although a few exemplary embodiments of the present invention have been shown and described, it will be appreciated by those skilled in the art that changes may be made in these embodiments without departing from the scope of the invention as defined in the appended claims.

## Claims

1. A double-sided display device (1; 200; 300; 400) arranged to display a first image perceivable on a first side of the device and to display a second image perceivable on a second opposed side of the device, the device comprising:
a first insulating substrate (110) comprising a first major surface and an opposed second major surface;
an organic light emitting layer (150; 152) which is formed in a first region in plan view on the second major surface of the first insulating substrate (110) and emits light;
a second insulating substrate (210) and a third insulating substrate (310) which are sequentially disposed in this order above the organic light
emitting layer (150; 152) relative to the first insulating substrate (110), wherein the third insulating substrate (310) comprises a first major surface facing the second insulating substrate (210) and an opposed second major surface;
a liquid crystal layer (410) which is formed in a second region in plan view between the second insulating substrate (210) and the third insulating substrate (310) with a smaller size in plan view than the first region defined by said organic light emitting layer (150; 152), the liquid crystal layer (410) being arranged to be backlit by light emitted from the organic light emitting layer (150; 152) towards and transmitted through the second insulating substrate (210);
wherein the liquid crystal layer (410) is arranged to modulate received light in order to display a first image perceivable on the side of the second major surface of the third insulating substrate (110);
**characterized by** a color provider (132, 132a - 132c; 640) arranged to provide color to light emitted from the organic light emitting layer (150; 152) towards and transmitted through the first insulating substrate (110) to the side of the first major surface of the first insulating substrate (110);
and in that the organic light emitting layer (150; 152) is arranged to emit spatially modulated light in order to display a second image perceivable on the side of the first major surface of the first insulating substrate (110).

2. The display device (1; 200; 300; 400) according to claim 1, wherein the liquid crystal layer (410) is overlapped with the organic light emitting layer (150; 152) in plan view.

3. The display device (1; 200; 300; 400) according to claim 1, the device further comprising:
a sealant (510) which adheres the first insulating substrate (110) and the second insulating substrate (210).

4. The display device (1; 200; 300; 400) according to claim 3, further comprising:
a moisture absorber (211; 611) which is provided on the surface of the second insulating substrate (210) which faces the first insulating substrate (110).

5. The display device (1; 200; 300; 400) according to claim 3, further comprising:
a thin film transistor (221) which is formed on the surface of the second insulating substrate (210) which faces the third insulating substrate (310).

6. The display device (1; 200; 300; 400) according to claim 1, wherein the color provider comprises a color filter (132,132a-132c) disposed between the first insulating substrate (110) and the organic light emitting layer (150; 152).

7. The display device (1; 200; 300; 400) according to claim 6, wherein the color provider comprises a color filter film (640) attached to the first major surface of the first insulating substrate (110).

8. The display device (1; 200; 300; 400) according to claim 1, further comprising:
a driving circuit substrate (171; 271) which is connected with the first insulating substrate (110); and
a flexible printed circuit board (261) which connects the second insulating substrate (210) and the driving circuit substrate (171; 271).

9. The display device (1; 200; 300; 400) according to claim 1, further comprising:
a first driving circuit substrate (171; 271) which is connected with the first insulating substrate (110); and
a second driving circuit substrate (171; 271) which is connected with the second insulating substrate (210).

10. The display device (1; 200; 300; 400) according to claim 1, further comprising:
a pixel electrode (141) which is formed under the organic light emitting layer (150; 152) and a common electrode (160; 341) which is formed on the organic light emitting layer (150; 152) relative to the first insulating substrate (110).

11. The display device (1; 200; 300; 400) according to claim 10, wherein the common electrode (160; 341) comprises silver and at least one of magnesium and calcium.

12. The display device (1; 200; 300; 400) according to claim 1, wherein the first insulating substrate (110) is larger than the second insulating substrate (210) in plan view, and the second insulating substrate (210) is larger than the third insulating substrate (310) in plan view.

13. The display device (1; 200; 300; 400) according to claim 1, further comprising:
a fourth insulating substrate (610) which is disposed between the first insulating substrate (110) and the second insulating substrate (210); and
a sealant (510) which adheres the first insulating substrate (110) to the fourth insulating substrate (610).

14. The display device (1; 200; 300; 400) according to claim 13, further comprising:
an optical film (630) which is disposed between the second insulating substrate (210) and the fourth insulating substrate (610).

## Patentansprüche

1. Doppelseitige Anzeigevorrichtung (1; 200; 300; 400), ausgeführt zur Anzelge eines ersten Bildes, das auf einer ersten Seite der Vorrichtung wahrnehmbar ist, und zur Anzeige eines zweiten Bildes, das auf einer zweiten, gegenüber liegenden Seite der Vorrichtung wahrnehmbar ist, wobei die Vorrichtung Folgendes umfasst:
ein erstes Isoliersubstrat (110), das eine erste Hauptfläche und eine gegenüber angeordnete zweite Hauptfläche umfasst;
eine organische lichtemittierende Schicht (150; 152), die in einem ersten Bereich in Draufsicht auf der zweiten Hauptfläche des ersten Isollersubstrats (110) gebildet ist und Licht emittiert;
ein zweites Isoliersubstrat (210) und ein drittes Isoliersubstrat (310), die hintereinander in dieser Reihenfolge über der organischen lichtemittierenden Schicht (150; 152) im Verhältnis zum ersten Isoliersubstrat (110) angeordnet sind, wobei das dritte Isoliersubstrat (310) eine erste Hauptfläche, die dem zweiten Isoliersubstrat (210) zugewandt ist, und eine gegenüber angeordnete zweite Hauptfläche umfasst;
eine Flüssigkristallschicht (410), die in einem zweiten Bereich in Draufsicht zwischen dem zweiten Isoliersubstrat (210) und dem dritten Isoliersubstrat (310) gebildet ist, mit einer geringeren Größe in Draufsicht als der erste von der organischen lichtemittierenden Schicht (150; 152) begrenzte Bereich,
wobei die Flüssigkristallschicht (410) so ausgeführt Ist, dass sie von Licht, das von der organischen lichtemittierenden Schicht (150; 152) emittiert wird, gegen das zweite Isoliersubstrat (210) und durch dieses hindurch hintergrund beleuchtet wird,
wobei die Flüssigkristallschicht (410) so ausgeführt ist, dass sie empfangenes Licht so moduliert, dass ein erstes Bild angezeigt wird, das auf der Seite der zweiten Hauptfläche des dritten Isoliersubstrats (110) wahrnehmbar ist;
**gekennzeichnet durch** einen Farbbereitsteller (132,132a - 132c; 640), der so ausgeführt ist, dass er dem Licht, das von der organischen lichtemittierenden Schicht (150; 152) gegen das erste Isoliersubstrat (110) und **durch** dieses hindurch zu der Seite der ersten Hauptfläche des ersten Isollersubstrats (110) emittiert wird, Farbe bereitstellt; und
**dadurch**, dass die organische lichtemittierende Schicht (150; 152) so ausgeführt ist, dass sie räumlich moduliertes Licht emittiert, um ein zweites Bild anzuzeigen, das auf der Seite der ersten Hauptfläche des ersten Isoliersubstrats (110) wahrnehmbar ist.

2. Anzeigevorrichtung (1; 200; 300; 400) gemäß Anspruch 1, wobei die Flüssigkristallschicht (410) von der organischen lichtemittierenden Schicht (150; 152) in Draufsicht überlappt wird.

3. Anzeigevorrichtung (1; 200; 300; 400) gemäß Anspruch 1, wobei die Vorrichtung ferner Folgendes umfasst:
einen Dichtstoff (510), der das erste Isoliersubstrat (110) und das zweite Isoliersubstrat (210) aneinander klebt.

4. Anzeigevorrichtung (1; 200; 300; 400) gemäß Anspruch 3, ferner umfassend:
einen Feuchtigkeitsabsorber (211; 611), der auf der Oberfläche des zweiten Isoliersubstrats (210) vorgesehen ist, welche dem ersten Isoliersubstrat (110) zugewandt ist.

5. Anzeigevorrichtung (1; 200; 300; 400) gemäß Anspruch 3, ferner umfassend:
einen Dünnschichttransistor (221), der auf der Oberfläche des zweiten Isoliersubstrats (210) gebildet ist, welche dem dritten Isoliersubstrat (310) zugewandt ist.

6. Anzeigevorrichtung (1; 200; 300; 400) gemäß Anspruch 1, wobei der Farbbereitsteller einen Farbfilter (132; 132a - 132c) umfasst, der zwischen dem ersten Isoliersubstrat (110) und der organischen lichtemittierenden Schicht (150; 152) angeordnet ist.

7. Anzeigevorrichtung (1; 200; 300; 400) gemäß Anspruch 6, wobei der Farbbereitsteller einen Farbfilterfilm (640) umfasst, der an der ersten Hauptoberfläche des ersten Isoliersubstrats (110) befestigt ist.

8. Anzeigevorrichtung (1; 200; 300; 400) gemäß Anspruch 1, ferner umfassend:
ein Treiberschaltungssubstrat (171; 271), das mit dem ersten Isoliersubstrat (110) verbunden ist; und
eine flexible Leiterplatte (261), die das zweite Isoliersubstrat (210) und das Treiberschaltungssubstrat (171; 271) verbindet.

9. Anzeigevorrichtung (1; 200; 300; 400) gemäß Anspruch 1, ferner umfassend:
ein erstes Treiberschaltungssubstrat (171; 271), das mit dem ersten Isoliersubstrat (110) verbunden ist; und
ein zweites Treiberschaltungssubstrat (171; 271), das mit dem zweiten Isoliersubstrat (210) verbunden ist.

10. Anzeigevorrichtung (1; 200; 300; 400) gemäß Anspruch 1, ferner umfassend:
eine Pixelelektrode (141), die unter der organischen lichtemittierenden Schicht (150; 152) gebildet Ist, und eine gemeinsame Elektrode (160; 341), die auf der organischen, lichtemittierenden Schicht (150; 152) im Verhältnis zu dem ersten Isoliersubstrat (110) gebildet ist.

11. Anzeigevorrichtung (1; 200; 300; 400) gemäß Anspruch 10, wobei die gemeinsame Elektrode (160; 341) Silber und mindestens eines von Magnesium und Calcium umfasst.

12. Anzeigevorrichtung (1; 200; 300; 400) gemäß Anspruch 1, wobei das erste Isoliersubstrat (110) größer ist als das zweite Isoliersubstrat (210) in Draufsicht, und wobei das zweite Isoliersubstrat (210) größer ist als das dritte Isoliersubstrat (310) in Draufsicht.

13. Anzeigevorrichtung (1; 200; 300; 400) gemäß Anspruch 1, ferner umfassend:
ein viertes Isoliersubstrat (610), das zwischen dem ersten Isoliersubstrat (110) und dem zweiten Isoliersubstrat (210) angeordnet ist; und
einen Dichtstoff (510), der das erste Isoliersubstrat (110) an das vierte Isoliersubstrat (610) klebt.

14. Anzeigevorrichtung (1; 200; 300; 400) gemäß Anspruch 13, ferner umfassend:
einen optischen Film (630), der zwischen dem zweiten Isoliersubstrat (210) und dem vierten Isoliersubstrat (610) angeordnet ist.

## Revendications

1. Dispositif d'affichage double face (1 ; 200 ; 300 ; 400) disposé de façon à afficher une première image perceptible sur une première face du dispositif et à afficher une deuxième image perceptible sur une deuxième face opposée du dispositif, lequel dispositif comprend :
un premier substrat isolant (110) comprenant une première grande surface et une deuxième grande surface opposée ;
une couche photoémettrice organique (150 ; 152) qui est formée dans une première région en vue en plan sur la deuxième grande surface du premier substrat isolant (110) et qui émet de la lumière ;
un deuxième substrat isolant (210) et un troisième substrat Isolant (310) qui sont disposés successivement dans cet ordre par-dessus la couche photoémettrice organique (150 ; 152) par rapport au premier substrat isolant (110) ; le troisième substrat isolant (310) comprenant une première grande surface faisant face au deuxième substrat isolant (210) et une deuxième grande surface opposée ;
une couche de cristaux liquides (410) formée dans une deuxième région en vue en plan entre le deuxième substrat isolant (210) et le troisième substrat isolant (310) d'une plus petite taille en vue en plan que la première région définie par ladite couche photoémettrice organique (150 ; 152), la couche de cristaux liquides (410) étant disposée pour être rétro-éclairée par la lumière émise par la couche photoémettrice organique (150 ; 152) vers le deuxième substrat isolant (210) et transmise à travers celui-ci ;
la couche de cristaux liquides (410) étant disposée pour moduler la lumière reçue de façon à afficher une première Image perceptible sur le côté de la deuxième grande surface du troisième substrat isolant (110) ;
**caractérisé en ce qu'**il comporte un générateur de couleur (132, 132a - 132c ; 640) disposé pour fournir de la couleur à la lumière émise par la couche photoémettrice organique (150 ; 152) vers le premier substrat isolant (110) et transmise à travers celui-ci vers le côté de la première grande surface du premier substrat isolant (110) ; et
**en ce que** la couche photoémettrice organique (150 ; 152) est disposée pour émettre une lumière modulée dans l'espace afin d'afficher une deuxième image perceptible du côté de la première grande surface du premier substrat isolant (110).

2. Dispositif d'affichage (1 ; 200 ; 300 ; 400) selon la revendication 1, dans lequel la couche de cristaux liquides (410) est recouverte par la couche photoémettrice organique (150 ; 152) en vue en plan.

3. Dispositif d'affichage (1 ; 200 ; 300 ; 400) selon la revendication 1, lequel dispositif comprend en outre un produit d'étanchéité (510) qui fait adhérer le premier substrat isolant (110) et le deuxième substrat Isolant (210).

4. Dispositif d'affichage (1 ; 200 ; 300 ; 400) selon la revendication 3, comprenant en outre un absorbeur d'humidité (211 ; 611) prévu sur la surface du deuxième substrat isolant (210) faisant face au premier substrat isolant (110).

5. Dispositif d'affichage (1 ; 200 ; 300 ; 400) selon la revendication 3, comprenant en outre un transistor à film mince (221) qui est formé sur la surface du deuxième substrat isolant (210) faisant face au troisième substrat isolant (310).

6. Dispositif d'affichage (1 ; 200 ; 300 ; 400) selon la revendication 1, dans lequel le générateur de couleur comprend un filtre coloré (132,132a-132c) disposé entre le premier substrat isolant (110) et la couche photoémettrice organique (150 ; 152).

7. Dispositif d'affichage (1 ; 200 ; 300 ; 400) selon la revendication 6, dans lequel le générateur de couleur comprend un film filtrant coloré (640) fixé à la première grande surface du premier substrat isolant (110).

8. Dispositif d'affichage (1 ; 200 ; 300 ; 400) selon la revendication 1, comprenant en outre un substrat de circuit d'excitation (171 ; 271) qui est connecté au premier substrat isolant (110) ; et
une carte de circuits imprimés flexible (261) qui relie le deuxième substrat isolant (210) et le substrat de circuit d'excitation (171 ; 271).

9. Dispositif d'affichage (1 ; 200 ; 300 ; 400) selon la revendication 1, comprenant en outre un premier substrat de circuit d'excitation (171 ; 271 qui est connecté au premier substrat isolant (110) et un deuxième substrat de circuit d'excitation (171 ; 271 ) qui est connecté au deuxième substrat isolant (210).

10. Dispositif d'affichage (1 ; 200 ; 300 ; 400) selon la revendication 1, comprenant en outre une électrode de pixel (141) qui est formée sous la couche photoémettrice organique (150 ; 152) et une électrode commune (160 ; 341) qui est formée sur la couche photoémettrice organique (150 ; 152) par rapport au premier substrat isolant (110).

11. Dispositif d'affichage (1 ; 200 ; 300 ; 400) selon la revendication 10, dans lequel l'électrode commune (160 ; 341) contient de l'argent et au moins soit du magnésium, soit du calcium.

12. Dispositif d'affichage (1 ; 200 ; 300 ; 400) selon la revendication 1, dans lequel le premier substrat isolant (110) est plus grand que le deuxième substrat isolant (210) en vue en plan et le deuxième substrat isolant (210) est plus grand que le troisième substrat isolant (310) en vue en plan.

13. Dispositif d'affichage (1 ; 200 ; 300 ; 400) selon la revendication 1, comprenant en outre un quatrième substrat isolant (610) qui est disposé entre le premier substrat isolant (110) et le deuxième substrat isolant (210) ; et
un produit d'étanchéité (510) qui fait adhérer le premier substrat isolant (110) au quatrième substrat isolant (610).

14. Dispositif d'affichage (1 ; 200 ; 300 ; 400) selon la revendication 13, comprenant en outre un film optique (630) disposé entre le deuxième substrat Isolant (210) et le quatrième substrat isolant (610).
